# EUROPEAN PATENT SPECIFICATION

(11) **EP 0 510 711 B1**
(45) Date of publication and mention of the grant of the patent: **27.06.2001**
(21) Application number: 92107141.1
(22) Date of filing: 27.04.1992
(51) Int. Cl.: C23C 18/20, C23C 18/16, H05K 3/42

(54) **Processes and compositions for electroless metallization**
Verfahren und Zusammensetzungen für die stromlose Metallisierung
Procédés et compositions pour la métallisation sans courant

(30) Priority: 25.04.1991 US 691565
(43) Date of publication of application: 28.10.1992
(73) Proprietor: Calvert, Jeffrey M., Burke, Virginia 22015 (US); Dressick, Walter J., Fort Washington, Maryland 20744 (US); Calabrese, Gary S., North Andover, Massachusetts 01845 (US); Gulla, Michael, Millis, Massachusetts 02054 (US)
(72) Inventor: Calvert, Jeffrey M., Burke, Virginia 22015 (US); Dressick, Walter J., Fort Washington, Maryland 20744 (US); Calabrese, Gary S., North Andover, Massachusetts 01845 (US); Gulla, Michael, Millis, Massachusetts 02054 (US)
(74) Representative: Bunke, Holger, Dr.rer.nat. Dipl.-Chem.

(56) References cited:
- EP-A- 0 098 346
- EP-A- 0 182 379
- EP-A- 0 229 344
- EP-A- 0 272 420
- EP-A- 0 506 993
- US-A- 3 326 719
- US-A- 3 523 874
- US-A- 4 066 804
- US-A- 4 701 351
- US-A- 4 981 715
- DATABASE WPI Week 8601 Derwent Publications Ltd., London, GB; AN 86-003172 XP002006777 & JP-A-60 228 678 (AGENCY OF IND SCI TECH) , 13 November 1985
- IBM TECHNICAL DISCLOSURE BULLETIN, vol. 7, no. 6, November 1964, NEW YORK US, page 417 XP002006776 G. E. MOORE ET AL.: "Resin surface coatings for polyester film"
- PATENT ABSTRACTS OF JAPAN vol. 12, no. 56 (C-477) [2903] , 19 February 1988 & JP-A-62 199773 (NIPPON SANMOU SENSHOKU KK), 3 September 1987,
- RESEARCH DISCLOSURE, no. 319, November 1990, HAVANT GB, page 912 XP000160217 31993: "Laser assisted, selective formation of electroless plating seed material"
- Römpps Chemie Lexikon, vol. 4, 8th edition, 1985, page 2586

## Description

### BACKGROUND OF THE INVENTION

### 1. Field of the Invention.

The present invention relates to a process for electroless metallization which process comprises the use of substrate chemical groups capable of ligating with an electroless metallization catalyst, and selective electroless plating through the use of such ligating groups. Said process is preferably used for metallizing through-holes of a printed circuit board.

### 2. Background Art.

Electroless metallization procedures typically require multiple and complex processing steps. See, for example, reviews of electroless plating in C. R. Shipley, Jr., Plating and Surface Finishing, vol. 71, pp. 92-99 (1984); and Metal Finishing Guidebook and Directory, vol. 86, published by Metals and Plastics Publications, Inc. (1988). One typical procedure for metallization of polymeric substrates employs a colloidal palladium-tin catalyst in the following sequence: (1) pre-cleaning the substrate surface; (2) microetching, for example with a chromic-based solution; (3) conditioning the etched substrate surface; (4) adsorption of the palladium-tin catalyst onto the conditioned surface; (5) treatment with an accelerator to modify and activate the absorbed catalyst; and (6) treatment with an electroless plating solution. See, for example, US-A-4,061,588 and 3,011,920. A number of fundamental studies have been performed on this and related electroless procedures. See, for example, J. Horkans, J. Electrochem. Soc., 130, 311 (1983); T. Osaka, et al., J. Electrochem. Soc., 127, 1021 (1980); R. Cohen, et al., J. Electrochem. Soc., 120, 502 (1973); and N. Feldstein, et al., J. Electrochem. Soc., 119, 668 and 1486 (1972).

While the exact composition and structure of such a Pd/Sn catalyst have not been confirmed, and the detailed mechanism by which a Pd/Sn colloid adheres to a substrate is not fully understood, the following is known and/or currently postulated. A palladium-tin electroless catalyst typically is generated by mixing multi-molar stannous chloride and a palladium chloride in an acidic aqueous solution containing excess chloride ion. Sn(II) reduces the Pd(II) species, likely via an inner-sphere redox reaction in a Pd/Sn complex, resulting in a colloidal suspension with a dense metallic core within a less dense tin polymer layer. The central portion of the colloid is composed of an intermetallic compound of stoichiometry reported to be Pd₃Sn. This inner core is believed to be a cluster containing up to 20 atoms with palladium principally in the zero and +1 oxidation states. This inner core is the actual catalyst in the initial metal reduction that leads to electroless metal deposition.

Surrounding this core is a layer of hydrolyzed stannous and stannic species that forms an outer shell of oxy- and/or hydroxy-bridged oligomers and polymers together with associated chloride ions. This layer is known as beta-stannic acid. The composition of the colloidal suspension contains a high concentration (multi-molar excess) of stannous ions relative to Pd which continue to hydrolyze and form higher oligomers on the outer surface of the initially formed colloidal particles. Consequently the thickness and degree of polymerization of the outer tin shell changes over time. The resultant colloidal particle has a net negative charge.

Adhesive properties of the outer polymeric outer shell attach the catalyst to the substrate to be plated, known in the art as the activation process. The negative charge of the outer tin shell prevents aggregation of the colloids permitting individual attachment to the substrate. The reducing power of the Sn(II) acts as an anti-oxidant and protective layer that maintains the catalytic core in the low valent Pd state necessary to initiate plating. Activation is followed by an acceleration step whereby the catalyst core is exposed. Acceleration can be achieved by a variety of means, for instance by "subtractive". type means of dissolving the stannous protective layer at high chloride ion concentrations to form soluble SnCl₄²⁻, or by oxidizing the shell to the more soluble Sn(IV) by exposure to oxygen from the ambient. "Additive" type acceleration sequences are also known. For example, EP-B-0 397 988 discloses the application of an acidic solution of PdCl₂ to the intact adsorbed colloid. The stannous polymer layer of the particle reduces the palladium ion in situ to form a metallic Pd deposit on which plating can occur.

After activation, the substrate is immersed in an electroless plating solution. A typical electroless metal plating solution comprises a soluble ion of the metal to be deposited, a reducing agent and such other ligands, salts and additives that are required to obtain a stable bath having the desired plating rate, deposit morphology and other characteristics. Common reductants include hypophosphite ion (H₂PO₂⁻), formaldehyde, hydrazine or dimethylamine-borane. The reductant reacts irreversibly at the catalyst core to produce an active hydrogen species, presumably a palladium hydride. The surface hydrogen is also a potent reductant which transfers electrons to the soluble metal complex in the bath and produces a metal deposit on top of the catalyst, which eventually covers the core sufficiently to block access to the external solution. For certain deposits, such as copper, nickel and cobalt, the nascent layer can itself become "charged" with hydrogen and continue to reduce metal ion to metal, leading to "autocatalytic" build-up of an electroless deposit onto the activated surface. In a competitive reaction, surface hydrogen atoms combine to evolve H₂ gas. This latter reaction has never been completely suppressed. Therefore, not all available reducing equivalents in the electroless bath can be used for metal deposition. For a properly catalyzed surface, the choice of electroless metal plating solution is determined by the desired properties of the deposit, such as conductivity, magnetic properties, ductility, grain size and structure, and corrosion resistance.

Such a palladium-tin catalyst system presents a number of limitations. At a minimum three steps are required -- activation, acceleration and plating. Often substrate pre-treatment and other additional steps are necessary to provide uniform plating. The colloidal catalyst also is readily oxidized and stannous ions must be replenished by regular addition of Sn(II) salts. Further, the colloid size may fix packing density thereby making difficult uniform plating of ultra-small objects, e.g. objects less than about 0.1 µm (1,000 angstroms) in size. Subtractive-type acceleration requires a precise and often difficult balance of exposing the palladium core without dissolving the portion of the stannous shell that provides adherence to the substrate surface. Further, substrate adhesion of a Pd/Sn catalyst has been found to be a relatively non-specific phenomenon. For example, the catalyst will only weakly adhere to a smooth photoresist coating, requiring a pre-etch step to provide a more textured surface and thereby increasing processing time and costs. For many situations, such as high resolution lithography, such pre-etching is not feasible. Further, a number of materials are "colloidophobic", i.e. materials to which a Pd/Sn catalyst does not adsorb. These materials include silica, certain metals and some plastics.

Recently, several electroless plating procedures have been reported, the procedures generally employing a palladium catalyst and a polyacrylic acid or polyacrylamide substrate coating. See, U.S. Patent Nos. 4,981,715 and 4,701,351; and Jackson, J. Electrochem. Soc., 135, 3172-3173 (1988).

In the process of US-A-4 981 715, a substrate is first coated with a layer of an acrylic polymer which is capable of ligating to a noble metal catalyst, preferably a palladium containing compound. Then, the resulting coated substrate is contacted with said noble metal catalyst to form a complex. Only thereafter, the complexed polymer is selectively irradiated in a predetermined pattern, chemically etched, rinsed and finally electrolessly metal plated.

In the process known from US-A-4 701 351, a substrate is dip-coated in a polyacrylic acid solution. Upon drying, the substrate is then coated with a permanent resist which is patternwise exposed and developed to define areas to be metallized. Subsequently, the substrate is coated with a noble metal compound, preferably a palladium compound, which binds to the complexing polymer where it was uncovered as a result of the resist development process, but does not bind to the photoresist. Finally, the substrate is selectively metallized in an electroless plating bath.

Still another process is known from US-A-4 066 804 wherein a substrate is used for metal deposition which consists of or contains compounds which in turn contain dicationic units which are converted *in situ* to radical cations or neutral compounds by means of radiation or heat. The converted substrate then is contacted first with a sensitizer such as a palladium salt and subsequently with an electroless plating solution.

JP-A-60 228 678 discloses a method of CVD metal film formation on a substrate which is treated first with a 4-vinylpyridine polymer and thereafter with a palladium salt solution. The thus treated surface is then electrolessly plated with nickel.

A common method for producing a patterned metallized image includes use of a photoresist coating. In an additive metallization approach, photoresist is applied to a substrate surface; the resist is exposed to provide selectively soluble portions of the photoresist coating; a developer is applied to bare selected portions of the substrate surface; those selected portions are metallized; and the remaining resist stripped from the substrate surface. See, generally, Coombs, Printed Circuits Handbook, ch. 11 (McGraw Hill 1988). A print and etch procedure is a subtractive approach where in the case of circuit line fabrication, a copper layer is selectively chemically etched through use of a photoresist to define the circuit traces. For higher performance applications, it is crucial that circuit sidewalls be uniform and essentially vertical. Resolution limits exist with a print and etch sequence, however, which are inherent in the subtractive nature of this approach.

### SUMMARY OF THE INVENTION

According to the present invention, the process for electroless metallization comprises the steps of:
(a) providing a substrate comprising one or more chemical groups comprising one or more moieties selected from the group consisting of aromatic heterocycle, thiol, phosphino, carboxylate, nitrile and ethylene diamine, with said chemical groups being capable of ligating to an electroless metallization catalyst, at least a portion of the chemical ligating groups being bonded to the substrate;
(b) selectively modifying the reactivity of said substrate to an electroless metallization catalyst by selective treatment of said chemical groups on selected areas of the substrate, with said treatment being selected from (1) using actinic radiation, (2) hydrolyzing chemical groups of the substrate, and (3) thermolysis;
(c) contacting the substrate resulting from step (b) with an electroless metallization catalyst that is tin-free; and
(d) contacting the substrate resulting from step (c) with an electroless metallization solution to form an electroless metal deposit on the substrate.

The one or more chemical groups capable of binding to the electroless catalyst may be provided by a variety of means. The material of construction of the substrate may comprise the catalyst ligating groups, for example a polyvinylpyridine substrate. Substrates that do not inherently comprise such ligating groups may be treated to provide the groups. For example, a source of the ligating groups may be formulated as a material of construction of the substrate. Alternatively, a substrate may comprise suitable precursor groups which upon appropriate treatment provide the necessary catalyst ligating groups. Such treatment will vary with the particular ligating group and includes, for example, thermolysis, treatment with chemical reagents, photochemical modification such as isomerization or photocleavage of a precursor group, and plasma etching. Further, such treatment methods can provide precursor groups, such as hydroxyl, carboxyl, amino and others to which a ligating group can be bonded. Still further, the ligating chemical groups or precursors thereof may be provided by contacting at least portions of the substrate surface with a compound or composition comprising the ligating groups, the ligating groups preferably adhering well to the substrate surface, for instance by chemical and/or physical interaction. If chemical bond formation is employed as the substrate adherence means, substrate adhesion and catalyst ligation functions may be performed by application of a single molecule or, alternatively, by application of multiple molecules with subsequent linkage therebetween.

A variety of tin-free metallization catalysts may be employed, with palladium (II) compounds and compositions preferred for the generally superior catalytic activity those catalysts provide. A substrate is preferably treated with a solution of the metallization catalyst, for example an aqueous solution or a solution of an organic solvent. The catalyst solution preferably comprises other materials such as ancillary ligands, salts and buffers to enhance the stability of the catalyst solution and thereby to provide suitable catalyst activity as well as convenient use and storage of the solution.

The substrate to be electrolessly plated according to the present invention may be a variety of materials such as a conductive material, a semiconductor material, an electrically nonconductive material, and more specifically, electronic packaging substrates such as a printed circuit board or a precursor thereof. In a preferred aspect, the invention is employed to metallize lipid tubule microstructures. It is believed that a wide variety of metals may be electrolessly plated in accordance with the present invention, for example cobalt, nickel, copper, gold, palladium and various alloys.

As is apparent to those skilled in the art, notable advantages of the invention include an electroless catalyst system that requires fewer and simpler processing steps in comparison to current Pd/Sn colloid catalyst adsorption based systems; use of more stable and convenient tin-free catalysts; and improved catalyst adhesion to a substrate allowing plating of more dense initiation and of greater uniformity and selectivity. The invention also provides selective patterning of substrate ligating groups, thereby enabling a selective metal deposit without the use of a conventional photoresist patterning sequence.

The terms- "ligate" or "ligating" or "ligation", as used herein in reference to the interaction between an electroless metallization catalyst and the substrate chemical groups of the invention, refers to any attraction, binding, complexing, chelating or sequestering, whatever the nature or extent of such attraction, binding, complexing, chelating or sequestering, between the catalyst and the substrate chemical group.

### DESCRIPTION OF THE PREFERRED EMBODIMENTS

Many substrates or substrate surfaces capable of being plated according to the present invention intrinsically contain chemical groups, or appropriate precursors of chemical groups, that are able to ligate an electroless plating catalyst. For example, a polyvinylpyridine film intrinsically contains such chemical groups with the pendant pyridine serving as the catalyst ligating group. As discussed herein, the pyridyl group has been found to be a particularly preferred ligating group for a palladium catalyst. For a discussion of the pyridyl moiety as a ligating group, see Calvert, et al., Inorganic Chemistry, 21, 3978 (1982). Further, the ligating material need not be the sole component of the substrate. Thus, the ligating material may be physically blended as one of multiple components comprising the substrate if sufficient ligating moieties are accessible at the substrate surface to ligate to the catalyst.

A possible shortcoming of such a blending approach is that incorporation of large quantities of a second material may impair the film-forming or other properties of the bulk material. A potential solution to this problem is to incorporate a surfactant form of the ligating component into the bulk material by proper choice of the relative solubility/polarity characteristics of the ligating component and the surfactant. By incorporating a small percentage of the surfactant into the bulk, a high surface concentration of the ligating component could be produced. An analogous approach has been employed in the photoresist arts, where a small quantity of surfactant is formulated into the resist to enhance film planarity by reducing the surface tension through a high surface concentration of surfactant.

Many substrates that do not inherently comprise suitable ligating groups may be readily modified to possess the necessary ligating groups. Substrate modification methods include, but are not limited to, thermolysis, reaction of the surface with one or more chemical reagents, irradiation with photons or ions, vapor phase modification, graft polymerization, x-ray and nuclear radiation treatment or, more generally, any treatment that effects the desired conversion of the substrate. One potential modification sequence provides hydrolysis of a polyimide surface and reacting the hydrolyzed surface with a silane reagent possessing a suitable ligating group, such as β-trimethoxysilylethyl-2-pyridine. Another method provides chemically etching a polyethylene surface with a Cr₂O₇²⁻ solution to provide hydroxyl groups on the substrate surface. The hydroxyl groups should then condense with a suitable compound containing a ligating group, for example nicotinoyl chloride with its pyridyl ligating group. Some of the surface substrate modification methods permit convenient selective treatment of a substrate surface. For example, if a surface can undergo a photochemical conversion to reveal a ligating group, that surface can be exposed to masked radiation and directly produce a pattern of catalyst binding sites. After treatment with a suitable catalyst, the patterned catalyst surface can then be electrolessly metallized to produce a negative tone image of the mask employed.

Rather than directly modifying the substrate, the substrate may be imparted with suitable ligating groups by indirect modification of the surface. For example, a substrate may be coated with one or more film layers, each layer comprising one or more suitable ligating agents. The film layer preferably adheres well to the substrate, for example by containing a functional group that will chemically and/or physically adhere to the substrate.

The adhesive and ligation functions of such a film may be performed by application of a single molecule or, alternatively, by application of multiple molecules with subsequent linkage between each of the molecules. For example, β-trimethoxysilylethyl-2-pyridine provides both ligating and substrate-adherent functionalities. The alkoxysilane group can chemically bind the compound to a substrate. For instance, the trimethoxysilyl group reacts with surface hydroxyl (silanol) functions of a quartz substrate, displacing methanol to directly bond to the substrate. The thus bound pyridyl moiety of the silylpyridyl molecule serves as a ligand for chelating with the plating catalyst.

As noted, the adhesive and ligating functions may be performed by multiple chemical groups with bond formation or other linkage between each of the groups. The linkage connecting the multiple functional groups may be of variable length and chemical composition. Examples include 3-(trimethoxysilyl) propylamine and a quinoline-8-sulfonic acid chloride. The aminosilane is applied as the substrate adsorbent. The coated surface is then reacted with a quinoline-8-sulfonic acid chloride, the SO₂Cl group coupling to the amine group of the coated surface to form a sulfonamide linkage, and the quinolinic group serving as a catalyst ligation moiety. Similarly, 3-(trimethoxysilyl) propylamine can be applied to a substrate and then reacted with the acid chloride group of 4,4'-dicarbonyl chloride-2,2'-bipyridine to form an amide linkage. The pyridyl moieties of this complex serve as catalyst ligating groups. Other silyl amines can be condensed in a similar manner, for example 3-(triethoxysilyl) propylamine. Another sequence provides condensing the hydroxyl groups of a chemically etched polyethylene substrate with a suitable ligating precursor, for example, 3-(trimethoxysilyl)propylamine, which after formation of the oxygen-silyl bond by methanol displacement, the amino group can condense with a suitable ligating compound such as nicotinoyl chloride.

A ligating chemical group comprising a radiation sensitive chromophore can provide selective photochemical patterning and metallization where selective photolysis or radiation ablation modifies the chemical groups on the substrate surface to substantially reduce or eliminate ligating ability in the selected film surface areas. Subsequent exposure to the plating catalyst and metallization solutions provides a positive tone image of the photomask employed. For example, the pyridyl group of β-trimethoxysilylethyl-2-pyridine serves as a chromophore for convenient patterning and subsequent selective metallization of the substrate surface through microlithographic techniques.

Analogously, a ligating film can be employed where selective photolysis transforms a non-ligating group within the film into a ligating group. For example, azoxybenzene derivatives photoisomerize from a weakly or non-ligating azoxybenzene group to the ligating 2-hydroxyazobenzene group. The chelating ability of 2-hydroxyazobenzene and 2-(2-pyridylazo)-1-naphthol has been described in Calabrese, et al., Inorg. Chem., 22, 3076 (1983). The Photo-Fries reaction is another potential means to provide suitable ligating groups. By this reaction, for example, polyacetoxystyrene can be irradiated with ultraviolet radiation to provide the ligating 2-hydroxyacetophenone moiety.

Depending on the nature of the radiation-sensitive materials employed, such transformations may be accomplished with a variety of exposure sources and imaging tools. For example, ultraviolet or visible light will be suitable for certain transformations, while other transformation may require exposure sources such as electron beam or x-ray treatment. Such energy sources can be provided by image tools known to those in the art, for example ultraviolet contact printers and projection steppers, electron beam writers and x-ray proximity printers.

For such patterning of a ligating film, the film preferably is an ultrathin film, which is a film defined herein to mean a film of a composite thickness of between about ten molecular layers and a single molecular (monomolecular) layer. Such a film can be formed through dip coating or vapor phase deposition procedures as are known in the art. A ligating film composed of multiple layers of ligating groups may not provide highly selective plating. Radiation exposure may fail to penetrate sufficiently the entire thickness of a multiple layer film leaving intact ligating groups in undesired substrate surface areas, thereby resulting in non-selective plating. As irradiation can readily penetrate through the thickness of an ultrathin film, such a film can be patterned with greater precision resulting in greater image resolution.

As described above, the invention provides a substrate surface containing a chemical functional group capable of binding metallization catalysts from solution. One way of binding a catalyst to a surface is by a metal-ligand complexation, or ligation reaction. Though not wishing to be bound by theory, the ability of a substrate ligand L to bind an electroless catalyst, for example a palladium (II) catalyst, should be readily determined by examining the formation equilibrium constant K_{f} for the generalized complexation reaction (I):${\text{Pd}}^{\text{2+}} {\text{+ L <---> PdL}}^{\text{2+}}$ wherein, K_{f} is equal to the ratio of concentration of products to reactants in reaction (I), i.e.,${\text{K}}_{\text{f}} \text{=} \frac{{\text{[PdL}}^{\text{2+}} \text{]}}{{\text{[Pd}}^{\text{2+}} \text{] [L]}}$

Large values of K_{f} would indicate strong, or essentially irreversible, binding of the catalyst to the ligand. See, generally, A. Martell, et al., "Critical Stability Constants", Plenum Press, New York (1975), where examples of complexation reactions have been tabulated. While little data has been reported for palladium (II) ligation reactions, the general trends for complexation reactions can be obtained by examining the formation constant values for Ni(II). Palladium is directly below nickel in the periodic table and has similar coordination properties. The results with nickel ion shows that through a chelate effect a multidentate ligand (chelate) provides a greater K_{f} than a corresponding monodentate group, where the term monodentate group refers to a chemical group that can provide only one ligand binding site, and the term multidentate group refers to chemical group or groups that can provide greater than one ligand binding site. For example, chelation of Ni(II) by 2,2'-bipyridine results in a complex that is 10,000 times more stable than a pyridine complex, and 30 times more stable than a bis-pyridine complex. Further, it is believed that a higher K_{f} provides a metal deposit with relatively greater adhesion to a substrate upon subsequent metallization.

Thus, a bipyridyl is preferred over a monopyridyl for the relatively stronger bond the bipyridyl forms with an electroless metallization catalyst and the higher quality metal deposit thereby provided. Use of suitable multidentate ligating groups has enabled deposition of thick adherent metal plates, including metal plates of thickness equal to and greater than about 0.25 µm (2500 angstroms) on smooth, unetched surfaces. In addition to bipyridyl, numerous other multidentate groups should also serve as suitable ligating groups, for example 2,2':6,2''-terpyridine, oxalate, ethylene diamine, 8-hydroxyquinoline and 1,10-phenanthroline. Organophosphines, nitriles, carboxylates and thiols should also ligate well, i.e. exhibit a significant K_{f}, with a palladium electroless metallization catalyst. For example, 3-mercaptopropyltriethoxysilane, 2-(diphenylphosphino)-ethyltriethoxysilane, and cyanomethylphenyl trimethoxysilane should serve as suitable catalyst ligating groups in accordance with the invention. Also preferred are ligating groups with antibonding (pi^{*}) orbitals in the ligand, for example aromatic heterocycles such as pyridine and other nitrogen containing aromatics. Such groups give rise to dpi->pi^{*} backbonding interactions that favor complex formation. It has thus been found that a benzyl chloride group provides poor ligating ability whereas an alkylpyridyl provides good ligation to an electroless catalyst.

A variety of compounds may be employed as the electroless catalyst in accordance with the invention, such as palladium, platinum, rhodium, iridium, nickel, copper, silver and gold. Palladium or palladium-containing compounds and compositions generally provide superior catalytic activity and therefore are preferred. Particularly preferred palladium species include bis-(benzonitrile)palladium dichloride, palladium dichloride and Na₂PdCl₄. Other salts of PdCl₄²⁻ should also be suitable, such as potassium and tetraethylammonium salts.

The electroless metallization catalysts useful in the processes of the invention are preferably applied to the substrate as a solution, for example as an aqueous solution or a solution of an organic solvent. Suitable organics include dimethylformamide, toluene, tetrahydrofuran, and other solvents in which the metallization catalyst is soluble at effective concentrations.

Means for contacting a substrate with a catalyst solution may vary widely and include immersion of the substrate in a solution as well as a spray application. The catalyst solution contact time required to provide complete metallization of the contact area can vary with catalyst solution composition and age.

A variety of catalyst solutions have been successfully employed, with solutions stabilized against decomposition preferred. Thus, the catalyst solution may comprise ancillary ligands, salts, buffers and other materials to enhance catalyst stability. Though again not wishing to be bound by theory, it is believed many of the catalyst solutions useful in the present invention decompose over time by oligomerization and formation of insoluble oxo-compounds, for example as reported by L. Rasmussen and C. Jorgenson, Acta. Chem. Scand., 22, 2313 (1986). It is believed the presence of catalyst oligomers in the catalyst solution can affect the ability of the catalyst to induce metallization and/or inhibit selectivity of metallization of a patterned substrate. For example, as such catalyst oligomers increase in molecular weight, their solubilities decrease and precipitation of the catalyst can occur.

Suitable agents for stabilizing a catalyst solution can vary with the particular catalyst employed, as is apparent to those skilled in the art. For instance, a metallization catalyst of PdCl₄²⁻ can be stabilized in aqueous solution by addition of excess chloride ion and decreasing pH to inhibit formation of oxo-bridged oligomers of the catalyst, of proposed structures such as Cl₃PdOPdCl₂(H₂O)³⁻ and Cl₃PdOPdCl₃⁴⁻. This is supported by the greater stability of catalyst solutions comprising sufficient concentrations of sodium chloride or tetraethylammonium chloride (TEACl) relative to the stability of PdCl₄²⁻ solutions not containing such agents. Such catalyst stabilization can be accomplished by adjustment of chloride ion concentration during preparation of the catalyst solution, or by adjustment of chloride ion concentration after the catalyst solution has attained full catalytic activity. In addition to chloride, other anions that prevent the formation of catalyst oligomers should also be suitable agents for stabilizing a catalyst solution, for example bromide and iodide ions.

Cation effects have also been observed. For example, suitable use of sodium chloride with Na₂PdCl₄ provides an active and stablilized catalyst solution. Replacing sodium chloride with ammonium chloride in such a solution, however, results in a solution with little or no activity as a metallization catalyst. In this case, it is believed that the lack of catalytic activity may be the result of the formation of stable cis- or trans-(NH₃)₂PdCl₂ species in solution. Replacing sodium chloride with TEACl provides a solution that requires a shorter induction period to reach full activity, and once active remains selective and stable only for a few days. It is further noted that while a number of cations may be suitable, cation selection may be dictated by the specific metallization process. For example, for advanced microelectronic applications, use of sodium ions generally is avoided if possible and, therefore, use of TEACl as a catalyst solution stabilizer may be preferred.

It also has been found that catalyst solutions of higher (less acidic) pH, e.g. pH of greater than 4, can be stabilized with a suitable buffer solution. Preferably, pH of a catalyst solution is controlled by a buffer component which does not appreciably coordinate with the metallization catalyst. For a Pd(II) metallization catalyst, a preferred buffering agent is 2-(N-morpholino)ethane sulfonic acid, referred to herein as MES, available from the Aldrich Chemical Company. This buffer has a pKₐ of 6.15 and has been described in Good, et al., Biochemistry, 5(2), pp. 467-477 (1966).

Additionally, it has been found that solution preparation methods can affect the stability and metallization activity of a catalyst solution useful in the invention. For example, the catalyst solutions disclosed in Examples 16 and 17 herein are prepared using approximately equivalent initial quantities of acetate buffer, sodium chloride and Na₂PdCl₄·3H₂O. In Example 16 herein, an aqueous catalyst solution comprising NaCl and Na₂PdCl₄·3H₂O reaches full activity as a metallization catalyst about 24 hours after preparation at room temperature. Addition of a prescribed amount of acetate buffer to this active solution maintains its catalytic activity. In contrast, preparation of a catalyst solution as described in Example 17 herein by simultaneous mixing of acetate buffer, NaCl and Na₂PdCl₄·3H₂O in aqueous solution yields a catalyst solution which requires about 11 days to reach full activity as a metallization catalyst.

It also has been found that components of a catalyst solution can compete with the catalyst for binding with substrate ligating sites. For example, for 4,4'-(di(carboxylic acid-(N-3-(trimethoxysilyl)propyl)amide))-2,2'bipyridine, the pKₐ values of the pyridyl groups are about 4.44 and 2.6, for mono- and di-protonation respectively. See, K. Nakamoto, J. Phys. Chem., 64, 1420 (1960). Thus, in the case of a PdCl₂/HCl (aq) catalyst solution, HCl may protonate the pyridyl groups and effectively compete for these sites with the palladium catalyst. While electrostatic interactions may still occur between the metallization catalyst and such a protonated ligating group, coordination type binding will be substantially reduced. It has thus been found that elimination of such ligation competitors from a catalyst solution increases coordination type binding of the catalyst to the substrate ligation functionality.

A wide variety of substrates may be used in accordance with the invention. For example, the substrate may comprise a conductive material such as tungsten or copper, e.g. a copper clad printed circuit board; a semiconductor material such as doped silicon; a dielectric material such as polymeric substrates or ceramic substrates used in electronics applications, and others such as a photoresist coating and glass and quartz substrates. Similarly, a variety of metals may be plated according to the invention including cobalt, nickel, copper, gold, palladium and alloys thereof, and other alloys such as the nickel-iron-boron alloy identified as permalloy. Suitable commercial electroless metallization baths include the nickel electroless plating solution identified as Niposit® 468 and sold by the Shipley Company of Newton, Massachusetts.

The processes of the invention are useful for virtually any electroless metallization process, such as electroless plating in printed circuit and printed circuit board manufacture, including metallization of through holes surfaces in double-sided or multilayer printed circuit boards; plating on ceramic materials such as ceramic resistors and ceramic circuit boards; and plating of integrated circuits. More specifically with respect to the metallization of printed circuit board through-holes, the present invention provides in general contacting the nonconductive through-hole walls with a compound or composition comprising electroless catalyst ligating groups. The ligating compound or composition can be admixed with a liquid carrier, and the through-holes surfaces treated with such admixture. After such conditioning, the treated through-holes surfaces are contacted with a suitable electroless catalyst (e.g., the catalyst solution described in Example 12 herein) and then the hole walls metallized according to standard procedures. Electroless nickel or copper plating of through hole walls is common.

The present invention is particularly useful for fabricating circuit lines in electronic printed boards. Electroless plating is an additive process enabling fabrication of high resolution circuit traces with nearly vertical sidewalls. The present invention permits fabrication of high resolution circuit lines without the use of a photoresist patterning sequence. For example, as discussed above, suitable ligating groups or precursors thereof can be selectively modified to provide ligating groups in a selective pattern on a substrate surface. Upon subsequent metallization, a metallized patterned image is provided.

The processes of the invention are also useful to metallize lipid tubule microstructures, which are hollow cylindrical structures composed of up to approximately ten bilayers. Characteristic diameters are between about 0.2 to 0.3 µm and wall thicknesses are between about 5 to 50 nm. It is believed the exposed phosphocholine head groups or phosphate groups of the lipid can serve as catalyst ligating groups.

As described in US-A-4,911,981, numerous applications for metallized tubules and metallized tubule composite materials are known, including absorbers of electromagnetic radiation, electron emissive surfaces and controlled release reagents. Prior lipid metallization procedures generally require numerous processing steps, resulting in breakage and considerable reduction in aspect ratios from the as-formed tubules to the metal-coated product. Preservation of the tubules' aspect ratio during the metallization process is highly desired for many applications of the microstructures. Metallization in accordance with the present invention saves processing time and steps relative to prior systems, and thus can lead to preservation of the aspect ratios of the tubules.

The invention will be better understood by reference to the following examples. Examples 1 to 19 are illustrating one or more of steps (a), (c) and (d) of the claimed process, only. Example 20 illustrates the complete process claimed.

### GENERAL COMMENTS

In the following Examples, all contact angle measurements were made with water by the sessile drop method with a water drop and an NRL Zisman-type contact angle goniometer. Ultraviolet absorption data was recorded on a Cary 2400 Spectrophotometer. For measurements of a film on a silica slide, molar absorption coefficients (ε) were calculated from measured absorbance values based on a surface concentration of 10M and a film pathlength of 2 x 10⁻⁷ cm. Nitrogen gas used for drying was filtered prior to use by passing through a 0.22 *µ*m filter. All water was deionized.

The following terms when capitalized in the Examples have the following meanings.

"Standard Cleaning Method" means immersing the substrate in a solution of 1:1 v/v concentrated HCl:methanol for 30 minutes. The substrate is water rinsed and immersed in concentrated sulfuric acid for 30 minutes, and then transferred to a container of boiling water and stored therein until use. Immediately prior to use, the clean substrate is removed from the boiling water bath and dried with nitrogen or, alternatively dipped in acetone.

"100% Co Metallization Bath" means a bath prepared as follows. 6.0 g of CoCl₂6H₂O, 10.0 g NH₄Cl and 9.8 g ethylenediaminetetraacetic acid disodium salt are dissolved in 150 mL of deionized water and the pH brought to 8.2 by addition of 1M NaOH (aq) solution. Added to three volumes of the Co solution is one volume of a solution consisting of 8.0 g of dimethylamine borane complex in 100 mL of water. "50% Metallization Bath" means a bath prepared by diluting one volume of the 100% Metallization Bath with one volume of water. "25% Metallization Bath" means a bath prepared by diluting one volume of the 100% Metallization Bath with three volumes of water.

"MES Buffer Solution" means a solution prepared as follows. 2.13 g MES·H₂O solid is added to 50 mL water with stirring until dissolution. The pH of the solution is adjusted to 4.9 to 5.0 by dropwise addition of dilute NaOH. The solution is diluted to 100 mL to produce the final buffer. This solution has a MES concentration of 0.1 M and is referred to herein as MES Buffer Solution A. MES Buffer Solutions B and C were prepared in a similar manner to MES Buffer Solution A, except that the pH of these solutions are 5.7 and 6.4, respectively.

### EXAMPLE 1

This example illustrates application of a ligating layer on a substrate surface by dip coating.

A 25.4 mm (one-inch) square fused silica slide (ESCO Products or Dell Optics) was cleaned by the Standard Cleaning Method. Contact angle of 5° was obtained indicating a clean hydrophilic substrate surface. The slide was dried under nitrogen and placed in a glass holder which permitted exposure of both faces of the slide. The assembly was placed in a beaker containing 250 mL of a toluene solution 1.0 mM in acetic acid and further containing 1% (v/v) β-trimethoxysilylethyl-2-pyridine (available from Huls America - Petrarch Systems). The solution was heated for about 40 minutes until reaching temperature of about 65°C. The solution remained clear and colorless throughout heating. The slide was removed from the solution and rinsed twice in toluene. The slide was then immediately baked for 3 minutes at 120°C on the surface of a hotplate to complete attachment of the silane compound. After heating, the slide had a contact angle of 45° indicating binding of the more hydrophobic silane compound to the hydrophilic quartz surface. Ultraviolet absorption spectrum of the thus coated slide versus a reference of an uncoated fused silica slide was taken. Absorption maxima were observed at 200 nm and 260 nm with ε = 4900 M⁻¹cm⁻¹ and 3700 M⁻¹cm⁻¹, respectively. Correspondence between this spectrum and the spectrum of β-trimethoxysilylethyl-2-pyridine in acetonitrile confirmed the binding of the silane compound to the fused silica surface. Calculations based on the relative intensities of the bands of the surface and solution analogs indicate an average surface coverage of approximately one molecular layer of the silane compound.

### EXAMPLE 2

This example illustrates application of a ligating film on a substrate surface by spin coating.

A 25.4 mm (one inch) square fused silica slide was cleaned by the Standard Cleaning Method and dried as in Example 1. The slide was placed on the vacuum chuck of a Headway Research Standard Model Spincoater. The top surface of the slide was completely covered with a methanol solution 1.0 mM in acetic acid and further containing 1% (v/v) β-trimethoxysilylethyl-2-pyridine. Excess solution was removed by spinning the slide at 6000 rpm for 30 seconds. The slide was then baked for 3 minutes at 120°C on the surface of a hotplate. After heating, the slide provided a contact angle of 44°. The ultraviolet absorption spectrum was qualitatively similar to that of the coated slide prepared in Example 1 although the spectral bands were more intense and broader than corresponding bands of the Example 1 spectrum, consistent with bulk film formation in this case.

### EXAMPLE 3

This example illustrates stripping of the outer layers of the bulk film to produce a surface film layer of thickness of between one and several molecular layers.

The coated silica slide produced in Example 2 was placed in a glass holder which permitted exposure of both faces of the slide. The assembly was immersed in tetrahydrofuran, and the solution was brought to a boil over 0.5 hour. The slide was removed from the solution, rinsed with room temperature tetrahydrofuran and dried under nitrogen. Ultraviolet absorption spectrum was comparable to the spectrum of the slide prepared in Example 1, indicating removal of the outer layers of the film to produce an ultrathin film on the substrate of thickness of one or several molecules.

### EXAMPLE 4

This example illustrates in situ formation of a ligating film precursor with subsequent attachment of the same to a substrate surface.

The ligating precursor was 4,4'-dicarbonyl chloride-2,2'-bipyridine. This compound was prepared by oxidation of 4,4'-dimethyl-2,2'-bipyridine (Aldrich Chemical Co.) with acidic potassium permanganate to 4,4'-dicarboxy-2,2'-bipyridine, as described in A. Sargeson et al., Aust. J. Chem., 39, 1053 (1986). A flask was charged with 3.5 g (1.39 mM) of this dicarboxy compound and 60 mL toluene (Aldrich Sure Seal), and then 50 mL (68.5 mM) of thionyl chloride (Aldrich Gold Label) was quickly added. The flask was outfitted with a reflux condenser with a CaSO₄ drying tube and the mixture refluxed for 6 hours. Virtually all of the initially insoluble material dissolved during reflux to provide a slightly cloudy yellow solution. The solution was cooled to room temperature and filtered through a fritted glass funnel. The filtrate was concentrated under reduced pressure, and the resulting solid repeatedly redissolved in toluene and concentrated under reduced pressure until all traces of thionyl chloride were removed. The resulting yellow solid (3.9 g) was treated with activated charcoal in boiling toluene and filtered. The filtrate was concentrated to about 25 mL. Upon cooling, 4,4'-dicarbonyl chloride-2,2'-bipyridine (2.6 g, 67%) crystallized out of the filtrate as an off-white solid, mp 142-144°C. Anal. Calcd for C₁₂H₆N₂Cl₂O₂: C, 51.27; H, 2.15; N, 9.97. Found: C, 51.32; H, 2.27; N, 9.54.

A flask contained in a drybox was charged with 0.0703 g (0.25 mM) of 4,4'-dicarbonyl chloride-2,2'-bipyridine and 50 mL of acetonitrile the solution heated to boil to facilitate dissolution. 50mL of acetonitrile was added and the solution cooled to room temperature. An excess portion (100*µ*L used; 69 *µ*L, 0.50 mMoles required) of triethylamine (Aldrich Gold Label) (the triethylamine previously dried through a column of Activity I alumina) was added followed by addition of 89 *µ*L (0.50 mM) of 3-(trimethoxysilyl)propylamine (Huls America - Petrarch Systems). Acetonitrile was added to increase the mixture volume to 250 mL and the reaction flask shaken. Ultraviolet absorption spectroscopy of the pale yellow solution confirmed coupling of 4,4'-dicarbonyl chloride-2,2'-bipyridine and 3-(trimethoxysilyl)propylamine to provide 4,4'-(di(carboxylic acid-(N-3-(trimethoxysilyl)propyl)amide))-2,2'-bipyridine, having molecular formula C₂₄H₃₈O₈N₄Si₂, the compound referred to herein as "UTF-14B3".

A fused silica slide was cleaned by the Standard Cleaning Method and placed in the pale yellow solution of the UTF-14B3 compound. The solution was heated to 60°C over a 40 minute period. The slide was then removed, rinsed twice in acetonitrile and baked for 3 minutes at 120°C on a hotplate. After heating, the coated slide provided a contact angle of about 15°. Ultraviolet absorption spectroscopy confirmed the binding of the UTF-14B3 compound to the slide surface and indicated a film thickness on the slide of between 1 and 2 molecular layers.

### EXAMPLE 5

This example illustrates the binding of a palladium electroless metallization catalyst to the UTF-14B3 compound by a sequential addition process.

A 0.002 M acetonitrile solution of the UTF-14B3 compound was prepared as in Example 4. Added to this solution was an equal volume of a 0.002 M acetonitrile solution of bis(benzonitrile)palladium dichloride. Ultraviolet absorption spectroscopy confirmed the binding of the palladium compound to the UTF-14B3 compound via the observation of new, broad absorption bands at about 220 nm and 327 nm characteristic of the catalyst-ligand complex.

### EXAMPLE 6

This example illustrates the binding of a palladium electroless metallization catalyst to the UTF-14B3 compound by a simultaneous addition process.

A flask in a drybox was charged with 4,4'-dicarbonyl chloride-2,2'-bipyridine, 3-(trimethoxysilyl)propylamine, bis(benzonitrile)-palladium chloride and triethylamine in a respective concentration ratio of 0.1 mM : 0.2 mM : 0.1 mM: 0.25 mM. 50 mL of acetonitrile was added to dissolve the solid. Acetonitrile was then added to increase the volume of the solution to 100 mL. Ultraviolet absorption spectroscopy of the red-orange solution matched the spectrum of Example 5 confirming formation of the UTF-14B3 compound and the binding thereto of the palladium catalyst.

### EXAMPLE 7

This example illustrates metallization of substrate surfaces.

A fused silica slide was coated with the UTF-14B3 compound as in Example 4 and then immersed in a solution of 84 mg of PdCl₂ per liter of 0.1 M HCl aqueous solution. The solution was gently stirred for 40 minutes and the slide then removed and rinsed twice in water. Ultraviolet absorption spectrum showed strong, broad absorption bands at 220 nm (ε = 70000 M⁻¹cm⁻¹) and a weaker band at 327 nm (ε = 9800 M⁻¹cm⁻¹) indicating binding of the catalyst. These bands were in agreement with those observed for the UTF-14B3 complex of PdCl₂ in acetonitrile (note Examples 5 and 6) and indicate that the surface-bound and solution phase complexes are similar. It was found that greater than 95 percent of the ligating sites of the UTF-14B3 surface had accepted a PdCl₂ species. A time dependence study of the uptake of PdCl₂ from the catalyst solution by the UTF-14B3 surface film was performed. The absorption intensity at 220 nm, which is proportional to the level of UTF-14B3 bound PdCl₂ in the film, was determined as a function of the exposure time of the UTF-14B3 film to the PdCl₂/HCl solution. The results showed that about 85% of the ligating sites had accepted the PdCl₂ catalyst after 15 minutes exposure of the UTF-14B3 film to the solution.

### EXAMPLE 8

This example illustrates the binding rate of the metallization catalyst from solution by the substrate ligating group can be dependent on the nature of the metallization catalyst solution.

A UTF-14B3 coated fused silica slide prepared as in Example 4 was treated with a solution of 11 mg of bis(benzonitrile) palladium dichloride in 100 mL of tetrahydrofuran. Ultraviolet spectrum absorption bands at 220 nm and 327 nm were observed following treatment indicating formation of the UTF-14B3 complex of PdCl₂ in the surface film. A time dependence binding study as per Example 7 indicated that binding was greater than 90% complete after a 5 minute treatment of the film with the catalyst solution. The time necessary to achieve a comparable degree of binding using the PdCl₂/0.1M HCl (aq) solution of Example 7 was greater than 15 minutes.

### EXAMPLE 9

This example illustrates the metallization of a substrate.

A fused silica slide coated with UTF-14B3 as in Example 4 was treated with PdCl₂/0.1 M HCl (aq) solution for 40 minutes as described in Example 7. The treated slide was water rinsed and placed in 25% Co Metallization Bath with gentle agitation for 4 minutes. Hydrogen gas evolution and metallization of the slide were observed during this time. A thin, homogeneous, mirror-like plate of Co metal was observed over the entire treated area of the slide. The slide was removed from the metallization bath, water rinsed twice and dried under nitrogen. Treatment of a fused silica slide uncoated with UTF-14B3 by the same procedure gave no metallization. Similarly, treatment of a UTF-14B3 coated fused silica slide with the 25% Co Metallization Bath, but without prior treatment with metallization catalyst solution, gave no metallization.

### EXAMPLE 10

This example illustrates binding of a metallization catalyst directly to a substrate surface.

An n-type, native oxide silicon wafer (available from Monsanto Co., St. Louis, MO) was cleaned by the Standard Cleaning Method and placed in a wafer carrier within a beaker. A fresh 0.001 M acetonitrile solution of the UTF-14B3 complex of PdCl₂ of Example 6 was added to the beaker, and the solution was allowed to stand at room temperature for 1.5 hours. The wafer was then removed, rinsed twice with fresh acetonitrile and baked for 3 minutes on a hotplate at 120°C. The wafer was then immersed in the 25% Co Metallization Bath for 4 minutes, rinsed twice with water and dried under nitrogen. A Co metal plate was observed over the entire area of the wafer treated with the catalyst solution. Treatment of a clean silicon wafer uncoated with the UTF-14B3 complex of PdCl₂ with the 25% Co Metallization Bath did not provide a metal deposit.

### EXAMPLE 11

This example illustrates removal of metallization catalyst bound to outer layers of a bulk surface ligating film. Reactivation of the resulting de-catalyzed film with additional metallization catalyst solution permits metallization of the surface.

A fused silica slide coated with a bulk film of β-trimethoxysilylethyl-2-pyridine from Example 3 was treated with PdCl₂/0.1 M HCl (aq) solution for 15 minutes as described in Example 7. Ultraviolet absorption spectroscopy of the treated slide showed an absorption band at 235 nm in addition to bands at about 200 nm and 260 nm. The 235 nm band is indicative of a surface bound β-trimethoxysilylethyl-2-pyridine complex of PdCl₂. The presence of the bands associated with the free surface bound β-trimethoxysilylethyl-2-pyridine indicated that not all ligation sites within the film had complexed PdCl₂. The fused silica slide was then immersed in heated tetrahydrofuran as described in Example 3. After removal of the slide from the tetrahydrofuran bath, ultraviolet absorption showed an absence of the surface bound PdCl₂ as evidenced by the disappearance of the 235 nm band. Failure of an identically treated slide to metallize upon immersion in the 25% Co Metallization Bath confirmed the absence of metallization catalyst on the surface. The remaining absorption bands at 200 nm and 260 nm were consistent in intensity and position with those observed for ligation films of approximate monomolecular average thickness described in Example 1. Subsequent treatment of this slide with fresh metallization catalyst solution restored the 235 nm absorption band to the spectrum and, upon immersion of the slide in the 25% Co Metallization Bath, Co metal deposited on the slide.

### EXAMPLES 12-18

These examples illustrate control of catalytic activity and stability of a metallization catalyst through formulation of catalyst solutions comprising specific additives. Each solution of the examples was tested for metallization selectivity as follows. An n-type, native oxide silicon wafer was dip coated with β-trimethoxysilylethyl-2-pyridine. This wafer and a second uncoated n-type, native oxide silicon wafer were each treated with the described catalyst solution for 15 minutes and water rinsed twice. Each wafer was then immersed in the 25% Co Metallization Bath for 4 minutes, water rinsed twice and dried under nitrogen. Each wafer was then examined for evidence and quality of metallization. Plating is considered selective if the coated wafer was metallized but no metallization of the uncoated wafer was observed. Plating is considered non-selective if both wafers metallize.

### Example 12

An electroless metallization catalyst solution preferred for its stability and catalytic activity and selectivity, was prepared as follows: a vessel was charged with 11 mg of Na₂PdCl₄·3H₂O in 1 mL of 1.0 M NaCl (aq) and water added to bring the volume of the mixture to 100 mL. The resulting clear green-yellow solution was initially inactive as a metallization catalyst. After standing at room temperature for 24 hours, the solution turned a deeper yellow color and exhibited high activity and selectivity as a Co metallization catalyst. Both catalyst activity and selectivity of the solution were maintained for more than 30 days without further treatment.

### Example 13

A solution was prepared by dissolving 8.6 mg. of Na₂PdCl₄·3H₂O in 100 mL water. Immediately after preparation, this solution exhibited selective Co metallization. However, the solution was unstable and decomposed within hours via precipitation of palladium-containing oligomers.

### Example 14

A solution was prepared by adding 10 mL of an aqueous 0.1 M tetraethylammonium chloride solution to 11 mg of Na₂PdCl₄·3H₂O in a 100 mL volumetric flask and diluting to the mark with water. The clear, yellow solution had pH 4.5 and was an active and selective Co metallization catalyst within one hour of preparation. Within 24 hours of preparation, this solution acquired a dull, dirty yellow color and visually exhibited evidence of faint particulate matter. The solution pH was approximately 4.2 at this time. The solution filtered through 0.22 *µ*m cellulose filters as well as unfiltered solution gave selective metallization. After 48 hours from preparation, the solution contained a solid precipitate and was unusable as a metallization catalyst.

### Example 15

An aqueous acetate buffer solution was prepared which was 0.5 M initially in both sodium acetate and acetic acid. 2 mL of this solution was added to 11 mg of Na₂PdCl₄·3H₂O in a 100 mL volumetric flask and the flask diluted to the mark with water. The solution was clear, green-yellow in color with pH 4.6 and was initially inactive as a metallization catalyst. Within 24 hours of preparation, the solution yellowed and became an active, though nonselective, metallization catalyst. Filtering as described for the solution of Example 14 did not affect the behavior of the solution. Solution pH remained stable (in the range of 4.6 to 4.7) for at least 2 days following preparation.

### Example 16

100 mL of the active catalyst solution of Example 12 was prepared, and 2 mL of the solution was removed and replaced with a 2 mL aliquot of a 0.5 M acetate aqueous buffer which was 0.5 M in both sodium acetate and acetic acid. The resulting clear, yellow solution had pH 4.55 and was an active, selective Co metallization catalyst. The solution remained an active, selective metallization catalyst for at least 2 days following its preparation, at which time it was yellow in color with pH 4.5.

### Example 17

A solution was prepared by simultaneous addition of 1 mL of NaCl (aq) solution and 2 mL of 0.5 M acetate aqueous buffer solution (the buffer solution 0.5 M in both sodium acetate and acetic acid) to 11 mg solid Na₂PdCl₄·3H₂O in a 100 mL volumetric flask. Following dissolution of the solid, the flask was diluted to the mark with water. The clear, green-yellow solution had pH 4.7. Although the pH remained stable at this value for at least 7 days, the solution exhibited no activity as a metallization catalyst during this time. The activity of the solution as a metallization catalyst increased slowly during the following 3 to 4 days. Approximately 11 days after preparation, the solution reached full activity as a selective Co metallization catalyst.

### Example 18

A solution was prepared by dissolving 11 mg of Na₂PdCl₄·3H₂O in 10 mL of 0.01 M NH₄Cl (aq) solution. The clear, green-yellow solution was inactive as a metallization catalyst for at least 2 days following preparation. A drop in pH from 3.8 to 3.5 occurred during this time.

### EXAMPLE 19

This example illustrates that a substrate requires a suitable ligating group for the substrate to be metallized in accordance with the present invention.

Three n-type, native oxide silicon wafers were cleaned by the Standard Cleaning Method. The first wafer was dip coated with β-trimethoxysilylethyl-2-pyridine as in Example 1. The second wafer was coated with a film of 4-chloromethylphenyltrimethoxysilane using the surface silanization procedure described in Example 1. Contact angles of 45° (first wafer) and 70° (second wafer) were obtained indicative of coating of the wafer surfaces. The third wafer was not coated and provided a contact angle of approximately 5°.

Each of the wafers was immersed in the active catalyst solution of Example 12 for 15 minutes, water rinsed and then immersed in the 25% Co Metallization Bath for 4 minutes. The wafers were removed from the Co bath, water rinsed and dried under nitrogen. A full, homogeneous, mirror-like plate of Co metal was observed on the β-trimethoxysilylethyl-2-pyridine coated wafer in areas treated with the catalyst solution. No Co metal plate was observed on either of the other wafers.

### EXAMPLE 20

This example illustrates selective electroless metallization according to the present invention.

Two n-type, thermal oxide 35 nm ([350 angstrom] oxide thickness) silicon wafers were cleaned by the Standard Cleaning Method and coated with β-trimethoxysilylethyl-2-pyridine as in Example 1. Film integrities were confirmed by contact angle measurements. The wafers were patterned with a serpentine mask using ultraviolet exposure with Karl Suss Model MJB 3 Contact Printer equipped with Karl Suss Model 507X Xenon Lamp (254 nm). UV power level was 6.0 mW/cm² at 254 nm and exposure time was 15 minutes. The first wafer was treated with the active catalyst solution of Example 12, and metallized by immersing the wafer in the 25% Co Metallization Bath for 4 minutes. The second wafer was treated with the Pd/Sn colloidal catalyst identified as Cataposit 44 (Shipley Company, Newton, Massachusetts) and metallized with cobalt by standard procedures. Each wafer was examined under an optical reflection microscope. For the wafer treated with the solution of Example 12, the completeness of metallization in the plated regions and the lack of debris in the clear fields were superior compared to the same characteristics of the wafer metallized with the Cataposit 44 catalyst.

## Claims

1. A process for electroless metallization, comprising the steps of:
(a) providing a substrate comprising one or more chemical groups comprising one or more moieties selected from the group consisting of aromatic heterocycle, thiol, phosphino, carboxylate, nitrile and ethylene diamine, with said chemical groups being capable of ligating to an electroless metallization catalyst, at least a portion of the chemical ligating groups being bonded to the substrate;
(b) selectively modifying the reactivity of said substrate to an electroless metallization catalyst by selective treatment of said chemical groups on selected areas of the substrate, with said treatment being selected from (1) using actinic radiation, (2) hydrolyzing chemical groups of the substrate, and (3) thermolysis;
(c) contacting the substrate resulting from step (b) with an electroless metallization catalyst that is tin-free; and
(d) contacting the substrate resulting from step (c) with an electroless metallization solution to form an electroless metal deposit on the substrate.

2. The process of claim 1 where said one or more moieties of aromatic heterocycle are pyridyl moieties.

3. The process of claim 1 or 2 where the substrate has one or more film layers thereon, the one or more film layers comprising said chemical ligating groups.

4. The process of claim 3 where said one or more film layers have a composite thickness of between one and ten molecules.

5. The process of any one of claims 1 to 4 where the metallization catalyst is a palladium catalyst.

6. The process of claim 5 where the metallization catalyst is selected from the group of bis-(benzonitrile)palladium dichloride, palladium dichloride, and salts of PdCl₄²⁻.

7. The process of any one of claims 1 to 6 where the substrate is contacted with a solution of the electroless metallization catalyst.

8. The process of claim 7 where said catalyst solution further comprises a buffering agent.

9. The process of claim 8 where said catalyst solution is an aqueous solution comprising a palladium catalyst, anions and a buffering agent.

10. The process of any one of claims 1 to 9 where the plating metal of the electroless metallization solution is selected from the group consisting of cobalt, nickel, copper, gold, platinum, palladium, permalloy, and alloys thereof.

11. The process of any one of claims 1 to 10 where at least portions of the substrate comprise one or more materials selected from the group of a dielectric material, a conductive material, and a semiconductor material.

12. The process of claim 11 where the substrate surface comprises a polyimide material.

13. The process of any one of claims 1 to 12 where the substrate is one or more tubules structures.

14. The process of claim 13 where the tubules have a diameter between about 0.2 and 0.3 *µ*m and a wall thickness between about 5 and 50 nm.

15. The process of claim 13 or 14 where the tubules comprise one or more lipid compounds.

16. Use of the process of any one of claims 1 to 15 for metallizing through-holes of a printed circuit board.

## Patentansprüche

1. Verfahren zur stromlosen Metallisierung, das folgende Schritte umfaßt:
a) Es wird ein Substrat mit einer oder mehreren chemischen Gruppen bereitgestellt, die eine oder mehrere Einheiten umfassen, die ausgewählt sind aus der aus einem aromatischen Heterozyklus, Thiol, Phosphino, Carboxylat, Nitril und Ethylendiamin bestehenden Gruppe, wobei die chemischen Gruppen befähigt sind, die Stellung eines Liganden eines Katalysators für die stromlose Metallisierung einzunehmen, wobei mindestens ein Teil der als Ligand dienenden chemischen Gruppen an das Substrat gebunden ist;
b) die Reaktivität des Substrats gegenüber einem Katalysator für die stromlose Metallisierung wird selektiv modifiziert durch selektive Behandlung der chemischen Gruppen auf ausgewählten Flächen des Substrats, wobei die Behandlung ausgewählt wird aus (1) der Verwendung aktinischer Strahlung, (2) der Hydrolyse chemischer Gruppen des Substrats und (3) der Thermolyse;
c) das nach Schritt (b) erhaltene Substrat wird mit einem zinnfreien Katalysator für die stromlose Metallisierung zusammengebracht und
d) das nach Schritt (c) erhaltene Substrat wird zur Bildung einer stromlosen Metallabscheidung auf dem Substrat mit einer Lösung für die stromlose Metallisierung behandelt.

2. Verfahren nach Anspruch 1, bei dem die eine oder mehreren Einheiten eines aromatischen Heterozyklus Pyridyl-Einheiten sind.

3. Verfahren nach Anspruch 1 oder 2, bei dem das Substrat mit einer oder mehreren dünnen Schichten beschichtet ist, wobei die eine oder mehreren dünnen Schichten die als Liganden dienenden chemischen Gruppen umfassen.

4. Verfahren nach Anspruch 3, bei dem die eine oder mehreren dünnen Schichten zusammen eine Dicke von zwischen einem und zehn Molekülen besitzen.

5. Verfahren nach einem der Ansprüche 1 bis 4, bei dem der Metallisierungskatalysator ein Palladiumkatalysator ist.

6. Verfahren nach Anspruch 5, bei dem der Metallisierungskatalysator ausgewählt wird aus der aus bis(Benzonitril)palladiumdichlorid, Palladiumdichlorid und Salzen von PdCl₄²⁻ bestehenden Gruppe.

7. Verfahren nach einem der Ansprüche 1 bis 6, bei dem das Substrat mit einer Katalysatorlösung für die stromlose Metallisierung behandelt wird.

8. Verfahren nach Anspruch 7, bei dem die Katalysatorlösung zusätzlich einen Puffer enthält.

9. Verfahren nach Anspruch 8, bei dem die Katalysatorlösung eine wäßrige Lösung ist, die einen Palladiumkatalysator, Anionen und einen Puffer umfaßt.

10. Verfahren nach einem der Ansprüche 1 bis 9, bei dem das Abscheidungsmetall der stromlosen Metallisierungslösung ausgewählt wird aus der aus Kobalt, Nickel, Kupfer, Gold, Platin, Palladium, Permalloy (Eisen-Nickel-Legierung) und deren Legierungen bestehenden Gruppe.

11. Verfahren nach einem der Ansprüche 1 bis 10, bei dem mindestens Teile des Substrats mindestens ein aus der aus einem dielektrischen Material, einem leitenden Material und einem halbleitenden Material bestehenden Gruppe ausgewähltes Material umfassen.

12. Verfahren nach Anspruch 11, bei dem die Substratoberfläche ein Polyimid-Material umfaßt.

13. Verfahren nach einem der Ansprüche 1 bis 12, bei dem das Substrat eine oder mehrere tubuläre Strukturen umfaßt.

14. Verfahren nach Anspruch 13, bei dem die Tubuli (Röhrchen) einen Durchmesser von zwischen etwa 0,2 und 0,3 µm und eine Wandstärke von zwischen etwa 5 und 50 nm besitzen.

15. Verfahren nach Anspruch 13 oder 14, bei dem die Tubuli eine oder mehrere Lipidverbindungen umfassen.

16. Verwendung des Verfahrens gemäß einem der Ansprüche 1 bis 15 zur Metallisierung von Durchgangslöchern einer Leiterplatte.

## Revendications

1. Procédé de métallisation sans courant, comprenant les étapes suivantes :
a) on fournit un substrat comprenant un ou plusieurs groupes chimiques comprenant une ou plusieurs unités sélectionnées dans le groupe composé d'un hétérocycle aromatique, de thiol, phosphino, carboxylate, nitrile et d'éthylènediamine, lesdits groupes chimiques étant capables de servir de ligand d'un catalyseur de métallisation sans courant, au moins une unitéie des groupes chimiques servant de ligand étant lié au substrat ;
b) on modifie sélectivement la réactivité du substrat par rapport à un catalyseur de métallisation sans courant par le traitement sélectif des groupes chimiques sur des surfaces sélectionnées du substrat, le traitement étant sélectionné parmi (1) l'utilisation de rayonnement actinique, (2) l'hydrolyse des groupes chimiques du substrat et (3) la thermolyse ;
c) le substrat obtenu après l'étape (b) est mis en contact avec un catalyseur de métallisation sans courant qui est exempt d'étain et
d) le substrat obtenu après l'étape (c) est traité avec une solution de métallisation sans courant pour former un dépôt de métal sans courant sur le substrat.

2. Procédé selon la revendication 1, dans lequel ladite une ou lesdites plusieurs unités formées par l'hétérocycle aromatique sont des unités de pyridyle.

3. Procédé selon la revendication 1 ou 2, dans lequel le substrat est revêtu d'une ou de plusieurs couches minces, ladite une ou lesdites plusieurs couches minces comprenant les groupes chimiques servant de ligands.

4. Procédé selon la revendication 3, dans lequel ladite une ou lesdites plusieurs couches minces possèdent ensemble une épaisseur entre une et dix molécules.

5. Procédé selon l'une quelconque des revendications 1 à 4, dans lequel le catalyseur de métallisation est un catalyseur de palladium.

6. Procédé selon la revendication 5, dans lequel le catalyseur de métallisation est sélectionné parmi le groupe de dichlorure de bis-(benzonitrile)palladium, de dichlorure de palladium et de sels de PdCl₄²⁻.

7. Procédé selon l'une quelconque des revendications 1 à 6, dans lequel le substrat est mis en contact avec une solution du catalyseur de métallisation sans courant.

8. Procédé selon la revendication 7, dans lequel la solution de catalyseur comprend en outre un tampon.

9. Procédé selon la revendication 8, dans lequel la solution de catalyseur est une solution aqueuse qui comprend un catalyseur de palladium, des anions et un tampon.

10. Procédé selon l'une quelconque des revendications 1 à 9, dans lequel le métal de déposition de la solution de métallisation sans courant est sélectionné parmi le groupe de cobalt, nickel, cuivre, or, platine, palladium, permalloy (alliage fer-nickel) et leurs alliages.

11. Procédé selon l'une quelconque des revendications 1 à 10, dans lequel au moins des parties du substrat comprennent un ou plusieurs matériaux sélectionnés parmi le groupe consistant en un matériau diélectrique, un matériau conducteur et un matériau semi-conducteur.

12. Procédé selon la revendication 11, dans lequel la surface du substrat comprend un matériau polyimide.

13. Procédé selon l'une quelconque des revendications 1 à 12, dans lequel le substrat comprend une ou plusieurs structures en tubulures.

14. Procédé selon la revendication 13, dans lequel les tubulures ont un diamètre entre environ 0,2 et 0,3 µm et une épaisseur de paroi entre environ 5 et 50 nm.

15. Procédé selon la revendication 13 ou 14, dans lequel les tubulures comprennent un ou plusieurs composés lipides.

16. Utilisation du procédé selon l'une quelconque des revendications 1 à 15 pour métalliser des trous de passage d'une carte imprimée.
